# EUROPEAN PATENT SPECIFICATION

(11) **EP 3 159 942 B1**
(45) Date of publication and mention of the grant of the patent: **27.01.2021**
(21) Application number: 16194194.3
(22) Date of filing: 17.10.2016
(51) Int. Cl.: H01L 31/0687, H01L 31/078, H01L 31/05, H01L 31/0304

(54) **MULTIJUNCTION METAMORPHIC SOLAR CELL ASSEMBLY FOR SPACE APPLICATIONS**
METAMORPHE MEHRFACHSOLARZELLENANORDNUNG FÜR RAUMFAHRTANWENDUNGEN
ENSEMBLES DE CELLULES SOLAIRES MÉTAMORPHIQUES À JONCTIONS MULTIPLES POUR APPLICATIONS SPATIALES

(30) Priority: 19.10.2015 US 201562243239 P; 26.08.2016 US 201615249204
(43) Date of publication of application: 26.04.2017
(73) Proprietor: SolAero Technologies Corp., Albuquerque, NM 87123 (US)
(72) Inventor: DERKACS, Daniel, Albuquerque, NM 87111 (US)
(74) Representative: adares Patent- und Rechtsanwälte Reininger & Partner GmbB

(56) References cited:
- US-A1- 2006 144 435
- US-A1- 2006 162 768
- US-A1- 2008 163 920
- US-A1- 2010 147 366
- US-A1- 2011 011 983
- US-A1- 2014 261 628
- L. M. Fraas ET AL: "34% Efficient InGaP/GaAs/GaSb Cell-Interconnected-Circuits for Line-Focus Concentrator Arrays", , October 2002 (2002-10), XP055109208, Retrieved from the Internet: URL:http://ntrs.nasa.gov/search.jsp?R=2003 0000588
- R. R. KING ET AL: "(Invited) Group-IV Subcells in Multijunction Concentrator Solar Cells", ECS TRANSACTIONS, vol. 50, no. 9, 15 March 2013 (2013-03-15) , pages 287-295, XP055135598, ISSN: 1938-6737, DOI: 10.1149/05009.0287ecst
- Daniel J. Aiken: "InGaP/GaAs/Ge multi-junction solar cell efficiency improvements using epitaxial germanium", Proceedings of 28th IEEE Photovoltaic Specialists Conference - 15-22 Sept. 2000 - Anchorage, AK, USA, 15 September 2000 (2000-09-15), pages 994-997, XP055614171, PISCATAWAY, NJ [US] DOI: 10.1109/PVSC.2000.916053 ISBN: 978-0-7803-5772-3
- Matthew P. Lumb ET AL: "Realizing the next generation of CPV cells using transfer printing", AIP CONFERENCE PROCEEDINGS, vol. 1679, 1 January 2015 (2015-01-01), pages 040007-1, XP055528047, NEW YORK, US ISSN: 0094-243X, DOI: 10.1063/1.4931518

## Description

### BACKGROUND OF THE INVENTION

### Field of the Invention

The present disclosure relates to solar cells and the fabrication of solar cells, and more particularly the design and specification of a multijunction solar cell using electrically coupled but spatially separated semiconductor bodies based on III-V semiconductor compounds.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to properly specify and manufacture. Typical commercial III-V compound semiconductor multijunction solar cells have energy efficiencies that exceed 27% under one sun, air mass 0 (AM0) illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at a specific future time, often referred to as the "end of life" (EOL).

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, the photons in a wavelength band that are not absorbed and converted to electrical energy in the region of one subcell propagate to the next subcell, where such photons are intended to be captured and converted to electrical energy, assuming the downstream subcell is designed for the photon's particular wavelength or energy band.

The individual solar cells or wafers are then disposed in horizontal arrays or panels, with the individual solar cells connected together in an electrical series and/or parallel circuit. The shape and structure of an array, as well as the number of cells it contains, are determined in part by the desired output voltage and current.

The efficiency of energy conversion, which converts solar energy (or photons) to electrical energy, depends on various factors such as the design of solar cell structures, the choice of semiconductor materials, and the thickness of each subcell. In short, the energy conversion efficiency for each solar cell is dependent on the optimum utilization of the available sunlight across the solar spectrum as well as the "age" of the solar cell, i.e. the length of time it has been deployed and subject to degradation associated with the temperature and radiation in the deployed space environment. As such, the characteristic of sunlight absorption in semiconductor material, also known as photovoltaic properties, is critical to determine the most efficient semiconductor to achieve the optimum energy conversion to meet customer requirements of intended orbit and lifetime.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as its exposure to radiation in the ambient environment over time. The designation and specification of such parameters is a non-trivial engineering undertaking, and would vary depending upon the specific space mission and customer design requirements. Such design variables are interdependent and interact in complex and often unpredictable ways. In the terminology of some, such parameters are NOT simple "result effective" variables to those skilled in the art confronted with complex design specifications and practical operational considerations.

As a result of the selection of such design variables, electrical properties such as the short circuit current density (J_{sc}), the open circuit voltage (V_{oc}), and the fill factor, which determine the efficiency and power output of the solar cell, are thereby affected by the slightest change in such design variables, and as noted above, to further complicate the calculus, such variables and resulting properties also vary over time (i.e. during the operational life of the system).

One electrical parameter of consideration taught by the present disclosure is the difference between the band gap and the open circuit voltage, or (E_{g}/q - V_{oc}), of a particular active layer. Again, the value of such parameter may vary depending on subcell layer thicknesses, doping, the composition of adjacent layers (such as tunnel diodes), and even the specific wafer being examined from a set of wafers processed on a single supporting platter in a reactor run. One of the important mechanical or structural considerations in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters. The present application is directed to solar cells with several substantially lattice matched subcells, but including at least one subcell which is lattice mismatched, and in a particular embodiment to a five junction (5J) solar cell using electrically coupled but spatially separated four junction (4J) semiconductor bodies based on III-V semiconductor compounds.

US 2014/261628 A1, the article L.M. Fraas et Al: "34% Efficient InGAP/GaAs/GaSb Cell-Interconnected-Circuits for Line-Focus Concentrator Arrays", October 2002, XP055109208, US 2006/144435 A1 and US 2006/162768 A1 disclose a solar cell module including a terminal of first polarity and a terminal of second polarity comprising a first semiconductor body including a tandem vertical stack of at least a first upper, a second and third bottom solar subcells; and a second 20 semiconductor body disposed adjacent and parallel to the first semiconductor body and including a tandem vertical stack of at least a first upper, a second and a third bottom solar subcells substantially identical to that of the first semiconductor body, the first upper subcell of the first and second semiconductor bodies having a top contact connected to the terminal of first polarity, the third bottom subcell of the second semiconductor body having a bottom contact connected to the terminal of second 25 polarity, wherein the third subcell of the first semiconductor body is connected in a series electrical circuit with the third subcell of the second semiconductor body so that the interconnection of subcells of the first and second semiconductor bodies forms at least a four junction solar cell, wherein the short circuit density (Jsc) of each of the bottom subcells is at least twice that of the first and second subcells. Daniel J. Aiken: "lnGaP/GaAs/Ge multi-junction solar cell efficiency improvements using epitaxial germanium", Proceedings of 28th IEEE Photovoltaic Specialists Conference, 15-22.09.2000, pages 994-997, XP055614171, discloses a four junction solar cell using epitaxially grown Germanium on an active Germanium substrate to form the two bottom subcells. Richard R. King et al: "Group-IV Subcells in Multijunction Concentrator Solar Cells", ECS Transactions, vol. 50, no. 9, 15 March 2013, p.287-295, XP055135598 discloses a five junction solar cell using epitaxially grown Germanium on an active Germanium substrate to form the two bottom subcells. P. Lumb et al.: "Realizing the next generation of CPV cells using transfer printing", AIP Conference Proceedings, vol. 1679, 28.09.2015, pages 040007-1 to -7, XP055528047, describes the manufacturing of a multijunction solar cell modules based on concentrator photovoltaics (CPV) technology using transfer printing.

### SUMMARY OF THE DISCLOSURE

### Objects of the Disclosure

It is an object of the present disclosure to provide increased photoconversion efficiency in a multijunction solar cell for space applications over the operational life of the photovoltaic power system.

It is another object of the present disclosure to provide in a multijunction solar cell in which the selection of the composition of the subcells and their band gaps maximizes the efficiency of the solar cell at a predetermined high temperature (in the range of 40 to 100 degrees Centigrade) in deployment in space at AM0 at a predetermined time after the initial deployment, such time being at least one year, and in the range of one to twenty-five years.

It is another object of the present disclosure to provide a four junction solar cell subassembly in which the average band gap of all four cells in the subassembly is greater than 1.44 eV, and to couple the subassembly in electrical series with at least one additional subcell in an adjacent solar cell subassembly.

It is another object of the present disclosure to provide a lattice mis-matched five junction solar cell in which the bottom subcell is intentionally designed to have a short circuit current that is substantially greater than current through the top three subcells when measured at the "beginning-of-life" or time of initial deployment.

It is another object of the present disclosure to provide a five-junction (5J) solar assembly assembled from two four-junction (4J) solar cell subassemblies so that the total current provided by the two subassemblies matches the total current handling capability of the bottom subcell of the assembly.

It is another object of the present disclosure to match the larger short circuit current of the bottom subcell of the solar cell assembly with two or three parallel stacks of solar subcells, i.e. a configuration in which the value of the short circuit current of the bottom subcell is at least twice, or at least three times, that of the solar subcells in each parallel stack which are connected in a series with the bottom subcell. Stated another way, given the choice of the composition of the bottom subcell, and there by the short circuit current of the bottom subcell, it is an object of the disclosure that the upper subcell stack be specified and designed to have a short circuit which is one - half or less than that of the bottom subcell.

### Features of the Invention

The subject-matter of the present invention is defined in independent claim 1. Briefly, and in general terms, the present disclosure describes solar cells that include a solar cell assembly of two or more solar cell subassemblies, each of which includes a respective monolithic semiconductor body composed of a tandem stack of solar subcells, where the subassemblies are interconnected electrically to one another.

As described in greater detail, the inventors of the present application have discovered that interconnecting two or more spatially split multijunction solar cell subassemblies can be advantageous. The spatial split can be provided for multiple solar cell subassemblies monolithically formed on a single substrate and remaining as a monolithic semiconductor body with distinct characteristics. Alternatively, the solar cell subassemblies can be physically separated or fabricated individually as separate semiconductor chips that can be coupled together electrically. (Such alternative embodiments are covered in parallel applications noted in the Reference to Related Applications).

One advantage of interconnecting two or more spatially split multijunction solar cell subassemblies is that such an arrangement can allow accumulation of the current from the upper subcells in the adjacent semiconductor bodies into the bottom subcells which have higher current generation ability.

One advantage of interconnecting two or more spatially split multijunction solar cell subassemblies is that such an arrangement can allow the bottom subcells of different subassemblies to be connected in electrical series, this boosting the maximum operational voltage and open circuit voltage associated with the solar cell assembly, and thereby improving efficiency.

Further, selection of relatively high band gap semiconductor materials for the top subcells can provide for increased photoconversion efficiency in a multijunction solar cell for outer space or other applications over the operational life of the photovoltaic power system. For example, increased photoconversion efficiency at a predetermined time (measured in terms of five, ten, fifteen or more years) after initial deployment of the solar cell can be achieved.

Thus, in one aspect, a monolithic solar cell subassembly includes a first semiconductor body including an upper first solar subcell composed of (aluminum) indium gallium phosphide ((Al)InGaP); a second solar subcell disposed adjacent to and lattice matched to said upper first subcell, the second solar subcell composed of (aluminum) (indium) gallium arsenide ((Al)(In)GaAs) or indium gallium arsenide phosphide (InGaAsP); and a bottom subcell lattice matched to said second subcell and composed of (indium) gallium arsenide (In)GaAs.

The aluminum (or Al) constituent element, or indium (or In), shown in parenthesis in the preceding formula means that Al or In (as the case may be) is an optional constituent, and in the case of Al, in this instance may be used in an amount ranging from 0% to 40% by mole fraction. In some embodiments, the amount of aluminum may be between 20% and 30%. The subcells are configured so that the current density of the upper first subcell and the second subcell have a substantially equal predetermined first value, and the current density of the bottom subcell is at least twice that of the predetermined first value.

Briefly, and in general terms, the present disclosure provides a five junction solar cell comprising:
(a) a first semiconductor body including:
   an upper first solar subcell composed of a semiconductor material having a first band gap, and including a top contact on the top surface thereof;
   a second solar subcell adjacent to said first solar subcell and composed of a semiconductor material having a second band gap smaller than the first band gap and being lattice matched with the upper first solar subcell;
   a third solar subcell adjacent to said second solar subcell and composed of a semiconductor material having a third band gap smaller than the second band gap and being lattice matched with the second solar subcell;
   an interlayer adjacent to said third solar subcell, said interlayer having a fourth band gap greater than said third band gap; and
   a fourth solar subcell adjacent to said interlayer and composed of a semiconductor material having a fifth band gap smaller than the fourth band gap and being lattice mismatched with the third solar subcell, and including a first contact on the top surface thereof, and a second contact on the bottom surface thereof;
(b) a second semiconductor body disposed adjacent and parallel to the first semiconductor body and including:
   an upper first solar subcell composed of a semiconductor material having a first band gap, and including a top contact on the top surface thereof;
   a second solar subcell adjacent to said first solar subcell and composed of a semiconductor material having a second band gap smaller than the first band gap and being lattice matched with the upper first solar subcell;
   a third solar subcell adjacent to said second solar subcell and composed of a semiconductor material having a third band gap smaller than the second band gap and being lattice matched with the second solar subcell and having a bottom contact;
   an interlayer adjacent to said third solar subcell, said interlayer having a fourth band gap greater than said third band gap; and
   a fourth solar subcell adjacent to said interlayer and composed of a semiconductor material having a fifth band gap smaller than the fourth band gap and being lattice mismatched with the third solar subcell, and including a first contact on the top surface thereof, and a second contact on the bottom surface thereof connected to the terminal of a second polarity;
(c) wherein the top contact of the first semiconductor body is electrically coupled with the top contact of the second semiconductor body and to a terminal of first polarity;
   wherein the first contact on the top surface of the fourth solar subcell of the first semiconductor body is electrically coupled with the bottom contact of the third solar subcell of the second semiconductor body;and
   the second contact on the bottom surface of the fourth solar subcell of the first semiconductor body is electrically coupled with the first contact on the top surface of the fourth solar subcell of the second semiconductor body thereof so as to form a five junction solar cell.

In some embodiments, additional layer(s) may be added in the cell structure without departing from the scope of the claims.

Some implementations can include additional solar subcells in one or more of the semiconductor bodies.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto.

### BRIEF DESCRIPTION OF THE DRAWINGS

The invention will be better and more fully appreciated by reference to the following detailed description when considered in conjunction with the accompanying drawings, wherein:
FIG. 1 is a graph representing the BOL value of the parameter E_{g}/q - V_{oc} at 28° C plotted against the band gap of certain ternary and quaternary materials defined along the x-axis;
FIG. 2A is a cross-sectional view of a first embodiment of a first semiconductor body including a four junction solar cell after several stages of fabrication including the growth of certain semiconductor layers on the growth substrate up to the contact layer and etching contact steps on lower levels according to the present disclosure;
FIG. 2B is a cross-sectional view of a first embodiment of a first semiconductor body of FIG. 2A after the next step of depositing a metal contact on the top surface;
FIG. 2C is a cross-sectional view of a second embodiment of a first semiconductor body of FIG. 2A;
FIG. 3 is a cross-sectional view of a first embodiment of a second semiconductor body including a four junction solar cell after several stages of fabrication including the growth of certain semiconductor layers on the growth substrate up to the contact layer, according to the present disclosure;
FIG. 4 is a cross-sectional view of an embodiment of a five junction solar cell after following electrical connection of the first and second semiconductor bodies according to the present disclosure;
FIG. 5 is a schematic diagram of the five junction solar cell of FIG. 4; and
FIG. 6 is a graph of the doping profile in the base and emitter layers of a subcell in the solar cell according to the present disclosure.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of multijunction solar cells (as well as inverted metamorphic multijunction solar cells) are disclosed in the related applications noted above. Some, many or all of such features may be included in the structures and processes associated with the non-inverted or "upright" solar cells of the present disclosure. However, more particularly, the present disclosure is directed to the fabrication of a multijunction lattice matched solar cell grown over a metamorphic layer which is grown on a single growth substrate which forms a solar cell subassembly. More specifically, however, in some embodiments, the present disclosure relates to multijunction solar cell subassemblies with direct band gaps in the range of 2.0 to 2.15 eV (or higher) for the top subcell, and (i) 1.65 to 1.8 eV, and (ii) 1.41 eV for the middle subcells, and 0.6 to 0.9 eV direct or indirect band gaps, for the bottom subcell, respectively, and the connection of two or more such subassemblies to form a solar cell assembly.

The conventional wisdom for many years has been that in a monolithic multijunction tandem solar cell , "... the desired optical transparency and current conductivity between the top and bottom cells... would be best achieved by lattice matching the top cell material to the bottom cell material. Mismatches in the lattice constants create defects or dislocations in the crystal lattice where recombination centers can occur to cause the loss of photogenerated minority carriers, thus significantly degrading the photovoltaic quality of the device. More specifically, such effects will decrease the open circuit voltage (V_{oc}), short circuit current (J_{sc}), and fill factor (FF), which represents the relationship or balance between current and voltage for effective output" (Jerry M. Olson, U.S. Patent No. 4,667,059, "Current and Lattice Matched Tandem Solar Cell").

As progress has been made toward higher efficiency multijunction solar cells with four or more subcells, nevertheless, "it is conventionally assumed that substantially lattice-matched designs are desirable because they have proven reliability and because they use less semiconductor material than metamorphic solar cells, which require relatively thick buffer layers to accommodate differences in the lattice constants of the various materials" (Rebecca Elizabeth Jones - Albertus et al., U.S. Patent No. 8,962,993).

Even more recently "...current output in each subcell must be the same for optimum efficiency in the series - connected configuration" (Richard R. King et al., U.S. Patent No. 9,099,595).

The present disclosure provides an unconventional four junction design (with three grown lattice matched subcells, which are lattice mismatched to the Ge substrate) that leads to significant performance improvement over that of traditional three junction solar cell on Ge despite the substantial current mismatch present between the top three junctions and the bottom Ge junction. This performance gain is especially realized at high temperature and after high exposure to space radiation by the proposal of incorporating high band gap semiconductors that are inherently more resistant to radiation and temperature.

As described in greater detail, the present application further notes that interconnecting two or more spatially split multijunction solar cell subassemblies (with each subassembly incorporating Applicant's unconventional design) can be even more advantageous. The spatial split can be provided for multiple solar cell subassemblies monolithically formed on the same substrate. Alternatively, the solar cell subassemblies can be fabricated as separate semiconductor chips that can be coupled together electrically.

In general terms, a solar cell assembly in accordance with one aspect of the present disclosure, can include a terminal of first polarity and a terminal of second polarity. The solar cell assembly includes a first semiconductor subassembly including a tandem vertical stack of at least a first upper, a second, third and fourth bottom solar subcells, the first upper subcell having a top contact connected to the terminal of first polarity. A second semiconductor subassembly is disposed adjacent to the first semiconductor subassembly and includes a tandem vertical stack of at least a first upper, a second, third, and fourth bottom solar subcells, the fourth bottom subcell having a back side contact connected to the terminal of second polarity. The fourth subcell of the first semiconductor subassembly is connected in a series electrical circuit with the third subcell of the second semiconductor subassembly. Thus, a five-junction solar assembly is assembled from two four-junction solar cell subassemblies.

In some cases, the foregoing solar cell assembly can provide increased photoconversion efficiency in a multijunction solar cell for outer space or other applications over the operational life of the photovoltaic power system.

Another aspect of the present disclosure is that to provide a five junction solar cell assembly composed of two interconnected spatially separated four junction solar cell subassemblies, the average band gap of all four subcells (i.e., the sum of the four band gaps of each subcell divided by 4) in each solar cell subassembly being greater than 1.44 eV.

Another descriptive aspect of the present disclosure is to characterize the fourth subcell as being composed of an indirect or direct band gap material such that the lowest direct band gap is greater than 0.75 eV, in some embodiments.

Another descriptive aspect of the present disclosure is to characterize the fourth subcell as being composed of a direct band gap material such that the lowest direct band gap is less than 0.90 eV, in some embodiments.

According to the invention the fourth subcell in each solar cell subassembly is germanium.

The indirect band gap of germanium at room temperature is about 0.66 eV, while the direct band gap of germanium at room temperature is 0.8 eV. Those skilled in the art will normally refer to the "band gap" of germanium as 0.66 eV, since it is lower than the direct band gap value of 0.8 eV.

The recitation that "the fourth subcell has a direct band gap of greater than 0.75 eV" is therefore expressly meant to include germanium as a possible semiconductor for the fourth subcell, although other semiconductor materials can be used as well.

More specifically, the present disclosure intends to provide a relatively simple and reproducible technique that does not employ inverted processing associated with inverted metamorphic multijunction solar cells, and is suitable for use in a high volume production environment in which various semiconductor layers are grown on a growth substrate in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

The lattice constants and electrical properties of the layers in the semiconductor structure are preferably controlled by specification of appropriate reactor growth temperatures and times, and by use of appropriate chemical composition and dopants. The use of a deposition method, such as Molecular Beam Epitaxy (MBE), Organo Metallic Vapor Phase Epitaxy (OMVPE), Metal Organic Chemical Vapor Deposition (MOCVD), or other vapor deposition methods for the growth may enable the layers in the monolithic semiconductor structure forming the cell to be grown with the required thickness, elemental composition, dopant concentration and grading and conductivity type.

The present disclosure is directed to, in one embodiment, a growth process using a metal organic chemical vapor deposition (MOCVD) process in a standard, commercially available reactor suitable for high volume production. More particularly, the present disclosure is directed to the materials and fabrication steps that are particularly suitable for producing commercially viable multijunction solar cells using commercially available equipment and established high-volume fabrication processes, as contrasted with merely academic expositions of laboratory or experimental results.

Prior to discussing the specific embodiments of the present disclosure, a brief discussion of some of the issues associated with the design of multijunction solar cells, and in particular metamorphic solar cells, and the context of the composition or deposition of various specific layers in embodiments of the product as specified and defined by Applicant is in order.

There are a multitude of properties that should be considered in specifying and selecting the composition of, inter alia, a specific semiconductor layer, the back metal layer, the adhesive or bonding material, or the composition of the supporting material for mounting a solar cell thereon. For example, some of the properties that should be considered when selecting a particular layer or material are electrical properties (e.g. conductivity), optical properties (e.g., band gap, absorbance and reflectance), structural properties (e.g., thickness, strength, flexibility, Young's modulus, etc.), chemical properties (e.g., growth rates, the "sticking coefficient" or ability of one layer to adhere to another, stability of dopants and constituent materials with respect to adjacent layers and subsequent processes, etc.), thermal properties (e.g., thermal stability under temperature changes, coefficient of thermal expansion), and manufacturability (e.g., availability of materials, process complexity, process variability and tolerances, reproducibility of results over high volume, reliability and quality control issues).

In view of the trade-offs among these properties, it is not always evident that the selection of a material based on one of its characteristic properties is always or typically "the best" or "optimum" from a commercial standpoint or for Applicant's purposes. For example, theoretical studies may suggest the use of a quaternary material with a certain band gap for a particular subcell would be the optimum choice for that subcell layer based on fundamental semiconductor physics. As an example, the teachings of academic papers and related proposals for the design of very high efficiency (over 40%) solar cells may therefore suggest that a solar cell designer specify the use of a quaternary material (e.g., InGaAsP) for the active layer of a subcell. A few such devices may actually be fabricated by other researchers, efficiency measurements made, and the results published as an example of the ability of such researchers to advance the progress of science by increasing the demonstrated efficiency of a compound semiconductor multijunction solar cell. Although such experiments and publications are of "academic" interest, from the practical perspective of the Applicants in designing a compound semiconductor multijunction solar cell to be produced in high volume at reasonable cost and subject to manufacturing tolerances and variability inherent in the production processes and suited for specific applications such as the space environment where the efficiency over the entire operational life is an important goal, such an "optimum" design from an academic perspective is not necessarily the most desirable design in practice, and the teachings of such studies more likely than not point in the wrong direction and lead away from the proper design direction. Stated another way, such references may actually "teach away" from Applicant's research efforts and the ultimate solar cell design proposed by the Applicants.

In view of the foregoing, it is further evident that the identification of one particular constituent element (e.g. indium, or aluminum) in a particular subcell, or the specification of the thickness, band gap, doping, or other characteristic of the incorporation of that material in a particular subcell, is interdependent on many other factors, and thus is not a single, simple "result effective variable" that one skilled in the art can simply specify and incrementally adjust to a particular level and thereby increase the efficiency of a solar cell at the beginning of life or the end of life, or over a particular time span of operational use. The efficiency of a solar cell is not a simple linear algebraic equation as a function of band gap, or the amount of gallium or aluminum or other element in a particular layer. The growth of each of the epitaxial layers of a solar cell in an MOCVD reactor is a non-equilibrium thermodynamic process with dynamically changing spatial and temporal boundary conditions that is not readily or predictably modeled. The formulation and solution of the relevant simultaneous partial differential equations covering such processes are not within the ambit of those of ordinary skill in the art in the field of solar cell design.

Another aspect of the disclosure is to match the larger short circuit current of the bottom subcell of the solar cell assembly with two or three parallel stacks of solar subcells, i.e. a configuration in which the value of the short circuit current of the bottom subcell is at least twice, or at least three times, that of the solar subcells in each parallel stack which are connected in series with the bottom subcell. Stated another way, given the choice of the composition of the bottom subcell, and thereby the short circuit current of the bottom subcell, the upper subcell stack is specified and designated to have a short circuit current which is one - third or less or is one - half or less than that of the bottom subcell.

Even when it is known that particular variables have an impact on electrical, optical, chemical, thermal or other characteristics, the nature of the impact often cannot be predicted with much accuracy, particularly when the variables interact in complex ways, leading to unexpected results and unintended consequences. Thus, significant trial and error, which may include the fabrication and evaluative testing of many prototype devices, often over a period of time of months if not years, is required to determine whether a proposed structure with layers of particular compositions, actually will operate as intended, in a given environment over the operational life, let alone whether it can be fabricated in a reproducible high volume manner within the manufacturing tolerances and variability inherent in the production process, and necessary for the design of a commercially viable device.

Furthermore, as in the case here, where multiple variables interact in unpredictable ways, the proper choice of the combination of variables can produce new and "unexpected results", and constitute an "inventive step" in designing and specifying a solar cell to operate in a predetermined environment (such as space), not only at the beginning of life, but over the entire defined operational lifetime.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

One aspect of the present disclosure relates to the use and amount of aluminum in the active layers of the upper subcells in a multijunction solar cell (i.e. the subcells that are closest to the primary light source). The effects of increasing amounts of aluminum as a constituent element in an active layer of a subcell affects the photovoltaic device performance. One measure of the "quality" or "goodness" of a solar cell subcell or junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g}/q - V_{oc} of a device, the higher the quality of the material in that device. (The charge q is introduced in the denominator for normalization purposes, since the band gap of a semiconductor material is measured in electron volts which is dimensioned in units of energy, and thus to compare the terms with the open circuit voltage, measured in volts, the band gap is divided by the charge in coulombs, which is 1.6 x 10⁻¹⁹ coulombs, to produce a parameter also measured in volts). There is a theoretical limit to this difference, known as the Shockley-Queisser limit. That is the best voltage that a solar cell junction can produce under a given concentration of light at a given temperature.

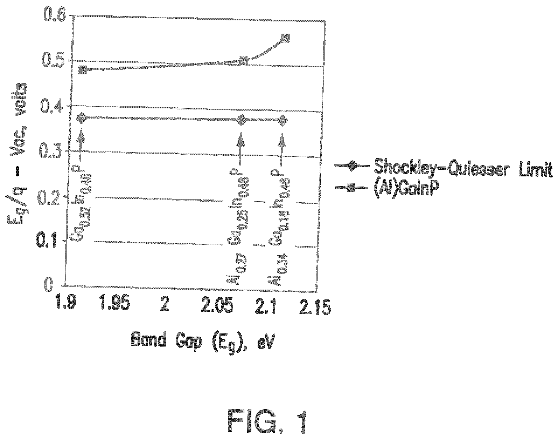

The experimental data obtained for single junction (Al)GaInP solar cells indicates that increasing the Al content of the junction leads to a larger E_{g}/q - V_{oc} difference, indicating that the material quality of the junction decreases with increasing A1 content. Figure 1 shows this effect. The three compositions cited in the Figure are all lattice matched to GaAs, but have differing A1 composition. As seen by the different compositions represented, with increasing amount of aluminum represented by the x-axis, adding more A1 to the semiconductor composition increases the band gap of the junction, but in so doing also increases E_{g}/q - V_{oc}. Hence, we draw the conclusion that adding A1 to a semiconductor material degrades that material such that a solar cell device made out of that material does not perform relatively as well as a junction with less Al.

Thus, contrary to the conventional wisdom as indicated above, the present application utilizes a substantial amount of aluminum, i.e., between 10% and 40% aluminum by mole fraction in at least the top subcell, and in some embodiments in one or more of the middle subcells as well. In some embodiments the amount of aluminum in each of the top three subcells is in excess of 20% by mole fraction.

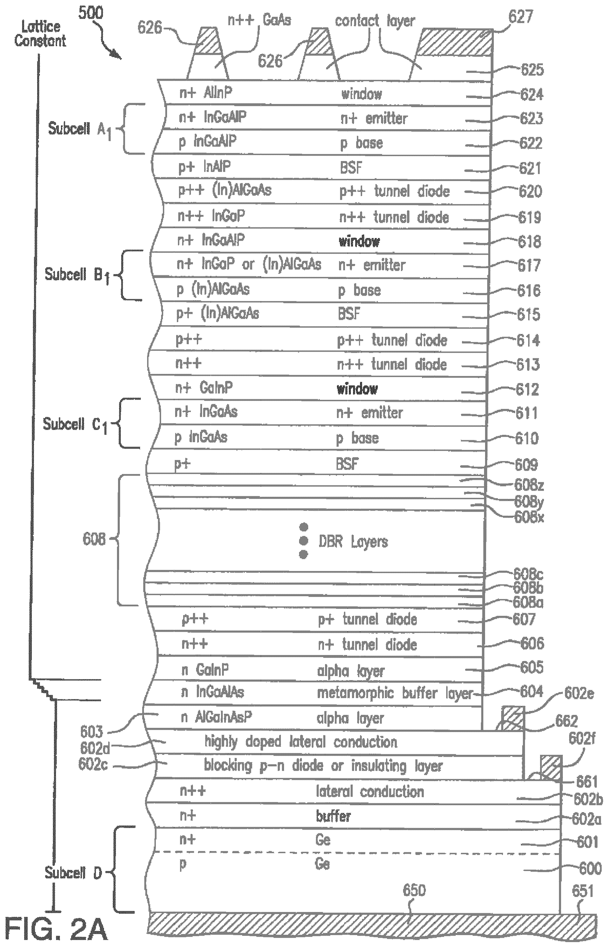

Turning to the fabrication of the multijunction solar cell assembly of the present disclosure, and in particular a five-junction solar cell assembly, FIG. 2A is a cross-sectional view of a first embodiment of a four junction solar cell subassembly 500 after several stages of fabrication including the growth of certain semiconductor layers on the growth substrate, and formation of grids and contacts on the contact layer of the semiconductor body.

As shown in the illustrated example of FIG. 2A, the bottom subcell D₁ includes a substrate 600 formed of p-type germanium ("Ge") in some embodiments, which also serves as a base layer. A back metal contact pad 650 formed on the bottom of base layer 600 provides electrical contact 651 to the multijunction solar cell subassembly 500.

In some embodiments, the contact 651 may be in the interior of the region 600 and not on the bottom surface of the region 600.

According to the invention the bottom subcell D₁ is germanium.

The bottom subcell D₁, further includes, for example, a highly doped n-type Ge emitter layer 601, and an n-type indium gallium arsenide ("InGaAs") nucleation layer 602a. The nucleation layer 602a is deposited over the base layer, and the emitter layer 601 is formed in the substrate by diffusion of atoms from the nucleation layer 602a into the Ge substrate, thereby forming the n-type Ge layer 601.

In the first solar cell subassembly 500 of FIG. 2A, a highly doped lateral conduction layer 602b is deposited over layer 602a, and a blocking p-n diode or insulating layer 602c is deposited over the layer 602b. A second highly doped lateral conduction layer 602d is then deposited over layer 602c.

In the embodiment of FIG. 2A, a first alpha layer 603, composed of n-type (Al)GaIn(As)P, is deposited over the lateral conduction layer 602d, to a thickness of between 0.25 and 1.0 micron. Such an alpha layer is intended to prevent threading dislocations from propagating, either opposite to the direction of growth into the bottom subcell D₁, or in the direction of growth into the subcell C₁, and is more particularly described in U.S. Patent Application Pub. No. 2009/0078309 A1 (Cornfeld et al.).

A metamorphic layer (or graded interlayer) 604 is deposited over the alpha layer 603 using a surfactant. Layer 604 is preferably a compositionally step-graded series of InGaAlAs layers, preferably with monotonically changing lattice constant, so as to achieve a gradual transition in lattice constant in the semiconductor structure from subcell D₁ to subcell C₁ while minimizing threading dislocations from occurring. The band gap of layer 604 is either constant throughout its thickness, in one embodiment approximately equal to 1.42 to 1.62 eV, or otherwise consistent with a value slightly greater than the band gap of the middle subcell C₁, or may vary within the above noted region. One embodiment of the graded interlayer may also be expressed as being composed of (Al)InₓGa₁₋ₓAs, with 0 < x < 1, and x selected such that the band gap of the interlayer is in the range of at approximately 1.42 to 1.62 eV or other appropriate band gap.

In the surfactant assisted growth of the metamorphic layer 604, a suitable chemical element is introduced into the reactor during the growth of layer 604 to improve the surface characteristics of the layer. In one embodiment, such element may be a dopant or donor atom such as selenium (Se) or tellurium (Te). Small amounts of Se or Te are therefore incorporated in the metamorphic layer 604, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAlAs, in the metamorphic buffer layer. Such Sb or Bi surfactants will not typically be incorporated into the metamorphic layer 606.

In one embodiment of the present disclosure, the layer 604 is composed of a plurality of layers of (Al)InGaAs, with monotonically changing lattice constant, each layer having a band gap, approximately in the range of 1.42 to 1.62 eV. In some embodiments, the band gap is in the range of 1.45 to 1.55 eV. In some embodiments, the band gap is in the range of 1.5 to 1.52 eV.

The advantage of utilizing the embodiment of a constant bandgap material such as InGaAs is that arsenide-based semiconductor material is much easier to process in standard commercial MOCVD reactors.

Although the preferred embodiment of the present disclosure utilizes a plurality of layers of (Al)InGaAs for the metamorphic layer 604 for reasons of manufacturability and radiation transparency, other embodiments of the present disclosure may utilize different material systems to achieve a change in lattice constant from subcell C₁ to subcell D₁. Other embodiments of the present disclosure may utilize continuously graded, as opposed to step graded, materials. According to the invention, the graded interlayer is composed of (Al)InₓGa₁₋ₓAs or InₓGa₁₋ₓP with 0 < x < 1, and (Al) designates that aluminum is an optional constituent, subject to the constraints of having the in-plane lattice parameter greater than or equal to that of the third solar cell and less than or equal to that of the fourth solar cell, and having a bandgap energy greater than that of the third solar cell.

A second alpha layer 605, composed of n+ type GaInP, is deposited over metamorphic buffer layer 604, to a thickness of between 0.25 and about 1.0 micron. Such second alpha layer is intended to prevent threading dislocations from propagating, either opposite to the direction of growth into the subcell D₁, or in the direction of growth into the subcell C₁, and is more particularly described in U.S. Patent Application Pub. No. 2009/0078309 A1 (Cornfeld et al.).

Heavily doped p-type aluminum gallium arsenide ("AlGaAs") and heavily doped n-type indium gallium arsenide ("(In)GaAs") tunneling junction layers 606, 607 may be deposited over the alpha layer 605 to provide a low resistance pathway between the bottom and middle subcells D₁ and C₁.

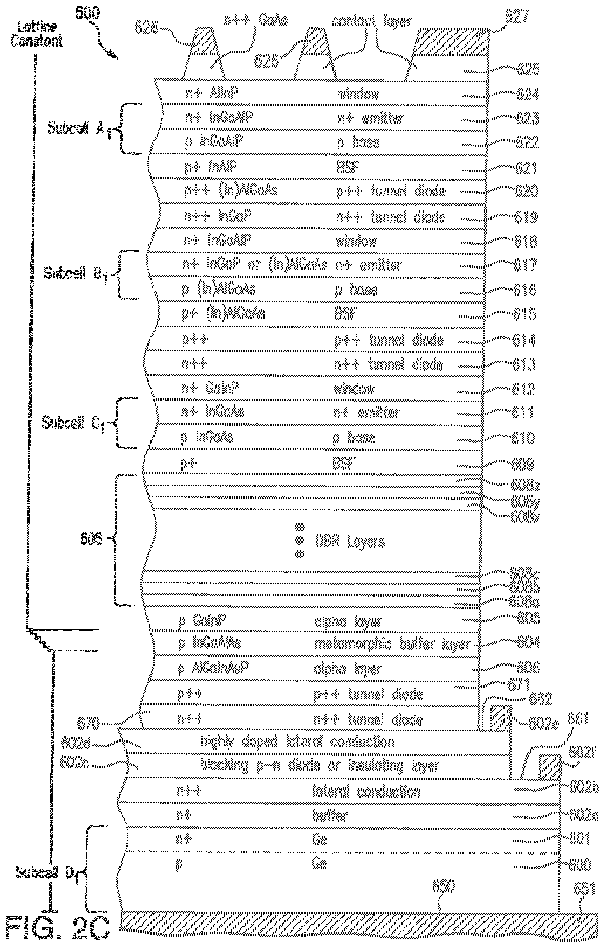

In some embodiments, distributed Bragg reflector (DBR) layers 608 are then grown adjacent to and between the tunnel junction 606/607 and the third solar subcell C₁. The DBR layers 608 are arranged so that light can enter and pass through the third solar subcell C₁ and at least a portion of which can be reflected back into the third solar subcell C₁ by the DBR layers 608. In the embodiment depicted in FIG. 2A, the distributed Bragg reflector (DBR) layers 608 are specifically located between the third solar subcell C and tunnel junction layers 607; in other embodiments, the distributed Bragg reflector tunnel diode layers 606/607 may be located between DBR layer 608 and the third subcell C₁. In another embodiment, depicted in FIG. 2C, the tunnel diode layer 670/671 are located between the lateral conduction layer 602d and the first alpha layer 606.

For some embodiments, distributed Bragg reflector (DBR) layers 608 can be composed of a plurality of alternating layers 608a through 608z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 608a through 608z includes a first DBR layer composed of a plurality of p type Alₓ(In)Ga₁₋ₓAs layers, and a second DBR layer disposed over the first DBR layer and composed of a plurality of p type Al_{y}(In)Ga_{1-y}As layers, where y is greater than x, with 0 < x < 1,0 < y < 1.

On top of the DBR layers 608 the subcell C₁ is grown.

In the illustrated example of FIG. 2A, the subcell C₁ includes a highly doped p-type aluminum gallium arsenide ("Al(In)GaAs") back surface field ("BSF") layer 609, a p-type InGaAs base layer 610, a highly doped n-type indium gallium phosphide ("InGaP2") emitter layer 611 and a highly doped n-type indium aluminum phosphide ("AlInP2") window layer 612. The InGaAs base layer 610 of the subcell C₁ can include, for example, approximately 1.5% In. Other compositions may be used as well. The base layer 610 is formed over the BSF layer 609 after the BSF layer is deposited over the DBR layers 608a through 608z.

The window layer 612 is deposited on the emitter layer 611 of the subcell C₁. The window layer 612 in the subcell C₁ also helps reduce the recombination loss and improves passivation of the cell surface of the underlying junctions. Before depositing the layers of the subcell B, heavily doped n-type InGaP and p-type Al(In)GaAs (or other suitable compositions) tunneling junction layers 613, 614 may be deposited over the subcell C₁.

The middle subcell B₁ includes a highly doped p-type aluminum (indium) gallium arsenide ("Al(In)GaAs") back surface field ("BSF") layer 615, a p-type Al(In)GaAs base layer 616, a highly doped n-type indium gallium phosphide ("InGaP2") or Al(In)GaAs layer 617 and a highly doped n-type indium gallium aluminum phosphide ("AlGaAlP") window layer 618. The InGaP emitter layer 617 of the subcell B₁ can include, for example, approximately 50% In. Other compositions may be used as well.

Before depositing the layers of the top cell A₁, heavily doped n-type InGaP and p-type Al(In)GaAs tunneling junction layers 619, 620 may be deposited over the subcell B.

In the illustrated example, the top subcell A₁ includes a highly doped p-type indium aluminum phosphide ("InAlP") BSF layer 621, a p-type InGaAlP base layer 622, a highly doped n-type InGaAlP emitter layer 623 and a highly doped n-type InAlP2 window layer 624. The base layer 623 of the top subcell A₁ is deposited over the BSF layer 621 after the BSF layer 621 is formed over the tunneling junction layers 619, 620 of the subcell B₁. The window layer 624 is deposited over the emitter layer 623 of the top subcell A₁ after the emitter layer 623 is formed over the base layer 622.

In some embodiments, the amount of aluminum in the top subcell A, is 20% or more by mole fraction.

A cap or contact layer 625 may be deposited and patterned into separate contact regions over the window layer 624 of the top subcell A₁. The cap or contact layer 625 serves as an electrical contact from the top subcell A₁ to metal grid 626. The doped cap or contact layer 625 can be a semiconductor layer such as, for example, a GaAs or InGaAs layer.

After the cap or contact layer 625 is deposited, the grid lines 626 are formed via evaporation and lithographically patterned and deposited over the cap or contact layer 625.

A contact pad 627 connected to the grid 626 is formed on one edge of the subassembly 500 to allow an electrical interconnection to be made, inter alia, to an adjacent subassembly.

As with the first solar cell subassembly 500, the subcells A₂, B₂, C₂ of the second solar cell subassembly 700 can be configured so that the short circuit current densities of the three subcells A₂, B₂, C₂ have a substantially equal predetermined first value (J1 <= J2 <= J3), and the short circuit current density (J4) of the bottom subcell D₂ is at least twice that of the predetermined first value.

Following deposition of the semiconductor layers, the semiconductor body 500 is etched so that several ledges or platforms are formed on intermediate layers so that electrical contact may be made thereto, in particular, in one embodiment, ledges 651, 661, and 662.

To this end, the solar cell subassembly can include a plurality of openings in the first semiconductor body, each of the openings extending from a top surface of the first semiconductor body to a different respective contact layer in the first semiconductor body. Such "openings" may include recesses, cavities, holes, gaps, cut-outs, or similar structures, but for simplicity we will subsequently just use the term "opening" throughout this disclosure. In other implementations, we can etch through the rear of the substrate and have all the openings come from the back side. This approach may be more efficient as it does not shadow the top two or top three solar subcells, but it results in a solar epitaxial structure of only a few tens of microns in thickness.

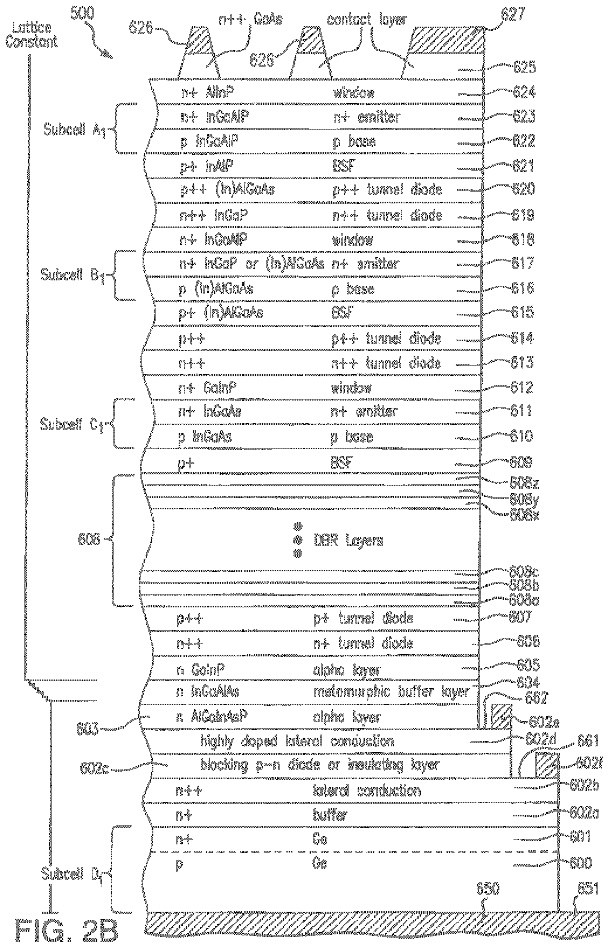

FIG. 2B is a cross-sectional view of the multijunction solar cell subassembly 500 of FIG. 2A after additional stages of fabrication including the deposition of metal contact pads on the ledges depicted in FIG. 2A.

A metal contact pad 602e is deposited on the surface of the ledge of 662 which exposes a portion of the top surface of the lateral conduction layer 602d. This pad 602e allows electrical contact to be made to the bottom of the stack of subcells A₁ through C₁.

A metal contact pad 602f is deposited on the surface of the ledge of 661 which exposes a portion of the top surface of the lateral conduction layer 602b. This pad 602f allows electrical contact to be made to the top of the subcell D₁.

A metal contact 651 is further provided to a ledge 650 in the p-region of the substitute 600, or as part of the back metal layer 660 which allows electrical contact to be made to the p-terminal of subcell D₁.

The solar cell subassemblies, 150 and 250 are presented in a highly simplified form, but each represent the structure 500 of FIG. 2.

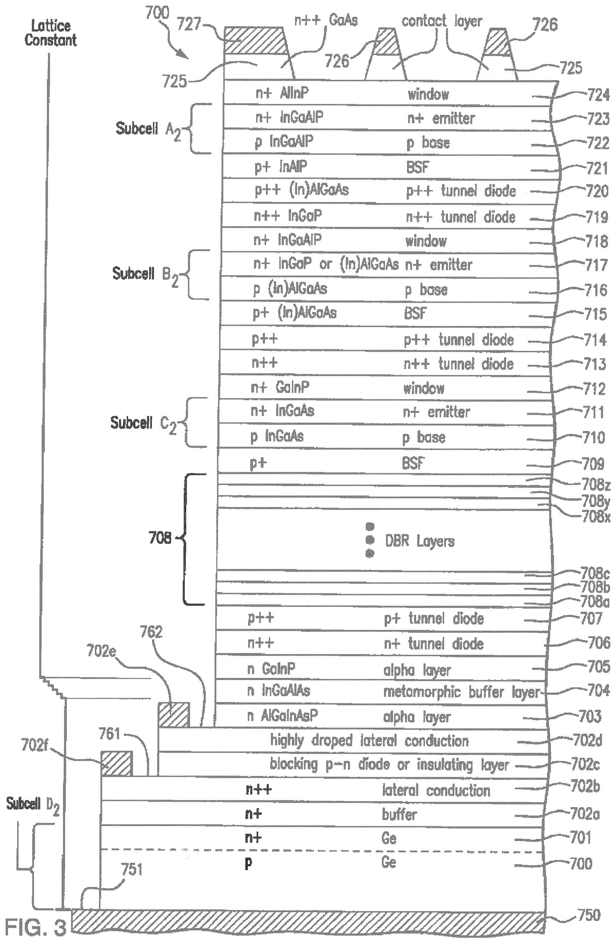

A second solar cell subassembly 700, which is similar to the solar cell subassembly 500 or 600 of FIG. 2B or 2C, respectively, may be formed with substantially the same sequence of semiconductor layers with the same compositions and band gaps as the corresponding layers in the first solar cell subassembly 500 or 600. Thus, the solar cell subassembly 700 also includes multiple subcells in a tandem stack. In the illustrated example of FIG. 3, the second solar cell subassembly 700 includes an upper first subcell (Subcell A₂), a second and third solar subcells (Subcell B₂ and C₂) disposed adjacent to and lattice matched to the upper first subcell A₂, and a bottom subcell (Subcell D₂) lattice mismatched to the third subcell C₂.

As with the first solar cell subassembly 500, the subcells A₂, B₂, C₂ of the second solar cell subassembly 700 can be configured so that the short circuit current densities of the three subcells A₂, B₂, C₂ have a substantially equal predetermined first value (J1 = J2 = J3), and the short circuit current density (J4) of the bottom subcell D₂ is at least twice that of the predetermined first value.

Since the semiconductor layers 700 through 725 in subassembly 700 are substantially identical to layers 600 through 625 in subassembly 500, a detailed description of them will not be illustrated or provided here for brevity.

In order to provide access to the various layers in the second solar cell subassembly 700, various ones of the layers can be exposed partially. Thus, as shown in the example of FIG. 3, various surfaces are partially exposed on the left side of the subassembly 700, for example, using standard photolithographic etching techniques to etch from the top surface of the semiconductor body 700 to the particular contact layer 762, 761 and 751 of interest.

A metal contact pad 703e is deposited on the surface of the ledge of 762 which exposes a portion of the top surface of the lateral conduction layer 702d. This pad 702e allows electrical contact to be made to the bottom of the stack of subcells A₂ through C₂.

A metal contact pad 702f is deposited on the surface of the ledge of 761 which exposes a portion of the top surface of the lateral conduction layer 702b. This pad 702f allows electrical contact to be made to the top of the subcell E.

A metal contact 751 is further provided as part of the back metal layer 750 which allows electrical contact to be made to the p-terminal of subcell E.

A second embodiment of the second solar cell subassembly similar to that of FIG. 2C is another configuration (not shown) with that the metamorphic buffer layer 604 is disposed above the tunnel diode layers 706, 707 and below the DBR layers 708 (not illustrated).

The foregoing multijunction solar cell subassemblies 500, 600, or 700 can be fabricated, for example, in wafer-level processes and then singulated or diced into individual semiconductor chips. The various semiconductor layers can be grown, one atop another, using known growth techniques (e.g., MOCVD) as discussed above.

Each solar cell subassembly 500, 600 and 700 also can include grid lines, interconnecting bus lines, and contact pads. The geometry and number of the grid lines, bus lines and/or contacts may vary in other implementations.

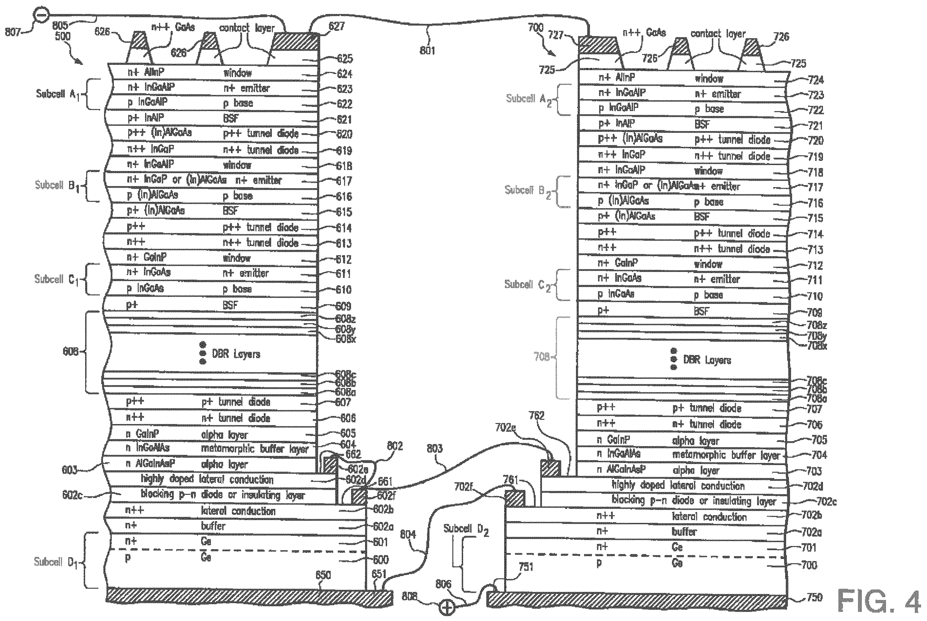

As previously mentioned, two (or more) solar cell subassemblies (e.g., 500 and 700) or chips can be disposed adjacent and parallel to one another and connected together electrically. For example, as shown in FIG. 4, conductive (e.g., metal) interconnections 801, 802, 803, and 804 can be made between different layers of the solar cell subassemblies 500 and 700. Some of the interconnections are made between different layers of a single one of the solar cell subassemblies, whereas others of the interconnections are made between the two different solar cell subassemblies. Thus, for example, the interconnection 801 electrically connects together the metal contacts 133 and 233 of the first and second solar cell subassemblies 150 and 250 respectively. In particular, interconnection 803 connects together a contact on the lateral conduction layer 104B of the first solar cell subassembly 150 to a contact on the lateral conduction layer 204b of the second solar cell subassembly 250. Similarly, the interconnection 804 connects together a contact 130 on the p-region 102 of the first solar cell subassembly 150 to a contact 231 on the lateral conduction layer 204a of the second solar cell subassembly 250. Likewise, the interconnection 802 connects together a contact 132 on the lateral conduction layer 104b of the first solar cell subassembly 150 to a contact 131 on the lateral conduction layer 104a of the first solar cell subassembly 150.

In some instances, multiple electrically conductive (e.g., metal) contacts can be provided for each of the respective contacts of the solar cell subassemblies 150, 250. This allows each of the interconnections 801 - 804 to be implemented by multiple interconnections between the solar cell subassembly layers rather than just a single interconnection.

As noted above, the solar cell assembly includes a first electrical contact of a first polarity and a second electrical contact of a second polarity. In some embodiments, the first electrical contact 807 is connected to the metal contact 160 on the first solar cell subassembly 150 by an interconnection 805, and the second electrical contact 808 is connected to the back metal contact 217 of the second solar cell subassembly 250.

As illustrated in FIG. 4, two or more solar cell subassemblies can be connected electrically as described above to obtain a multijunction (e.g. a four-, five- or six-junction) solar cell assembly. In FIG. 4, the top side (n-polarity) conductivity contact 807 and bottom side (p-polarity) conductive contact 808 for the solar cell assembly are schematically depicted respectively, at the left and right-hand sides of the assembly.

In the example of FIG. 4, one solar cell subassembly 150 includes an upper subcell A₁, two middle subcells B₁, C₁ and a bottom subcell D₁. The other solar cell subassembly includes an upper subcell A₂, two middle subcells B₂, C₂ and a bottom subcell D₂. In some implementations, each solar cell subassembly 500, 700 has band gaps in the range of 2.0 to 2.20 eV (or higher) for the top subcell, and (i) 1.65 to 1.8, and (ii) 1.41 eV for the middle subcell, and 0.6 to 0.9 eV, for the bottom subcell, respectively, Further, in some embodiments, the average band gap of all four subcells (i.e., the sum of the four band gaps of each subcell divided by four) in a given solar cell subassembly 500 or 700 is greater than 1.44 eV. Other band gap ranges may be appropriate for some implementations.

In some instances, the fourth (i.e., bottom) subcell is composed of germanium. The indirect band gap of the germanium at room temperature is about 0.66 eV, while the direct band gap of germanium at room temperature is 0.8 eV. Those skilled in the art with normally refer to the "band gap" of germanium as 0.66 eV, since it is lower than the direct band gap value of 0.8 eV. Thus, in some implementations, the fourth subcell has a direct band gap of greater than 0.75 eV. Reference to the fourth subcell having a direct band gap of greater than 0.75 eV is expressly meant to include germanium as a possible semiconductor material for the fourth subcell, although other semiconductor materials can be used as well. For example, the fourth subcell may be composed of InGaAs, GaAsSb, InAsP, InAlAs, or SiGeSn, or other III-V or II-VI compound semiconductor materials.

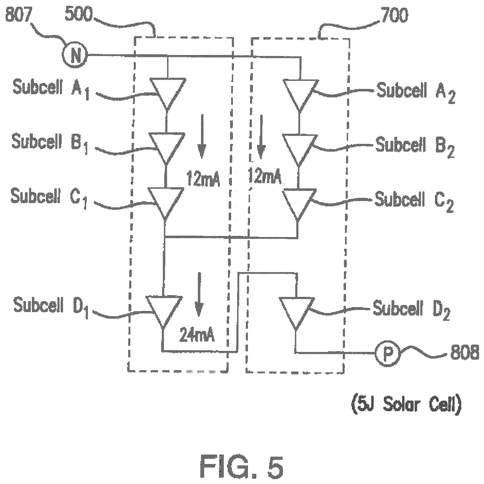

FIG. 5 is a schematic diagram of the five junction solar cell assembly of FIG. 4.

In some implementations of a five-junction solar cell assembly, such as in the example of FIG. 5, the short circuit density (J_{sc}) of the upper first subcells (A₁ and A₂) and the middle subcells (B₁, B₂, C₁, C₂) is about 12 mA/cm², and the short circuit current density (J_{sc}) of the bottom subcells (D₁ and D₂) is about 24 mA/cm² or greater. Other implementations may have different values.

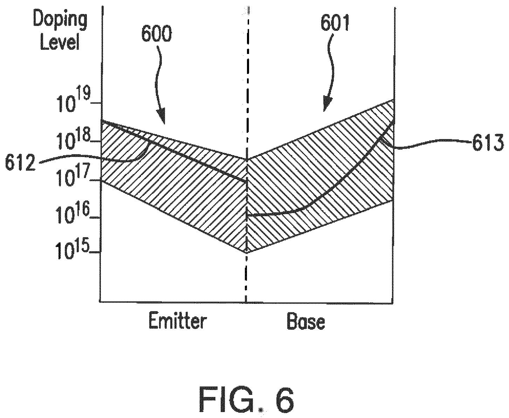

FIG. 6 is the graph of a doping profile in the emitter and base layers in one or more subcells of the multijunction solar cell of the present invention. The various doping profiles within the scope of the present invention, and the advantages of such doping profiles are more particularly described in U.S. Patent Application Serial No. 11/956,069 filed December 13, 2007. The doping profiles depicted herein are merely illustrative, and other more complex profiles may be utilized as would be apparent to those skilled in the art without departing from the scope of the claims.

The present disclosure like that of the parallel applications noted above provides a multijunction solar cell that follows a design rule that one should incorporate as many high band gap subcells as possible to achieve the goal to increase the efficiency at high temperature EOL. For example, high band gap subcells may retain a greater percentage of cell voltage as temperature increases, thereby offering lower power loss as temperature increases. As a result, both high temperature beginning-of-life (HT-BOL) and HT-EOL performance of the exemplary multijunction solar cell, according to the present disclosure, may be expected to be greater than traditional cells.

The open circuit voltage (V_{oc}) of a compound semiconductor subcell loses approximately 2 mV per degree C as the temperature rises, so the design rule taught by the present disclosure takes advantage of the fact that a higher band gap (and therefore higher voltage) subcell loses a lower percentage of its V_{oc} with temperature. For example, a subcell that produces a 1.50V at 28° C produces 1.50 - 42^{∗}(0.0023) = 1.403V at 70° C which is a 6.4% voltage loss, A cell that produces 0.25V at 28° C produces 0.25 - 42^{∗}(0.0018) = 0.174V at 70° which is a 30.2% voltage loss.

In view of different satellite and space vehicle requirements in terms of temperature, radiation exposure, and operational life, a range of subcell designs using the design principles of the present disclosure may be provided satisfying typical customer and mission requirements, and several embodiments are set forth hereunder, along with the computation of their efficiency at the end-of-life. The radiation exposure is experimentally measured using 1 MeV electron fluence per square centimeter (abbreviated in the text that follows as e/cm²), so that a comparison can be made between the current commercial devices and embodiments of solar cells discussed in the present disclosure.

As an example, a low earth orbit (LEO) satellite will typically experience radiation equivalent to 5 x 10¹⁴ e/cm² over a five year lifetime. A geosynchronous earth orbit (GEO) satellite will typically experience radiation in the range of 5 x 10¹⁴ e/cm² to 1 x 10 e/cm² over a fifteen year lifetime.

For example, the cell efficiency (%) measured at room temperature (RT) 28° C and high temperature (HT) 70° C, at beginning of life (BOL) and end of life (EOL), for a standard three junction commercial solar cell (e.g. a SolAero Technologies Corp. Model ZTJ), such as depicted in FIG. 2 of U.S. Patent Application Serial No. 14/828,206, is as follows:

| Condition | Efficiency | |
|---|---|---|
| BOL 28° C | 29.1% | |
| BOL 70° C | 26.4% | |
| EOL 70° C | 23.4% | After 5E14 e/cm² radiation |
| EOL 70°C | 22.0% | After 1E15 e/cm² radiation |

For the 5J solar cell assembly (comprising two interconnected four-junction subassemblies) described in the present disclosure, the corresponding data is as follows:

| Condition | Efficiency | |
|---|---|---|
| BOL 28° C | 30.6% | |
| BOL 70° C | 27.8% | |
| EOL 70° C | 26.6 % | After 5E14 e/cm² radiation |
| EOL 70° C | 26.1% | After 1E15 e/cm² radiation |

The new solar cell of the present disclosure has a slightly higher cell efficiency than the standard commercial solar cell (ZTJ) at BOL at 70° C. However, more importantly, the solar cell described in the present disclosure exhibits substantially improved cell efficiency (%) over the standard commercial solar cell (ZTJ) at 1 MeV electron equivalent fluence of 5 x 10¹⁴ e/cm², and dramatically improved cell efficiency (%) over the standard commercial solar cell (ZTJ) at 1 MeV electron equivalent fluence of 1 x 10¹⁵ e/cm².

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. However, consideration of the EOL E_{g}/q - V_{oc} metric, or more generally, total power output over a defined predetermined operational life, in the present disclosure presents a different approach. In short, increased BOL E_{g}/q - V_{oc} may be the most problematic shortcoming of aluminum containing subcells; the other limitations can be mitigated by modifying the doping schedule or thinning base thicknesses.

It will be understood that each of the elements described above, or two or more together, also may find a useful application in other types of structures or constructions differing from the types of structures or constructions described above.

## Claims

1. A multijunction solar cell assembly having a terminal of a first polarity (807) and a terminal of a second polarity (808) comprising:
(a) a first semiconductor body (500) including:
an upper first solar subcell (A1) composed of a semiconductor material having a first band gap, and including a top contact (627) on the top surface thereof;
a second solar subcell (B1) adjacent to said first solar subcell (A1) and composed of a semiconductor material having a second band gap smaller than the first band gap and being lattice matched with the upper first solar subcell (A1);
a third solar subcell (C1) adjacent to said second solar subcell (B1) and composed of a semiconductor material having a third band gap smaller than the second band gap and being lattice matched with the second solar subcell (B1);
an interlayer adjacent to said third solar subcell (C1), said interlayer having a fourth band gap greater than said third band gap; and
a fourth solar subcell (D1) adjacent to said interlayer and composed of a semiconductor material having a fifth band gap smaller than the fourth band gap and being lattice mismatched with the third solar subcell (C1), and including a first contact (602f) on the top surface thereof, and a second contact (650) on the bottom surface thereof;
(b) a second semiconductor body (700) disposed adjacent and parallel to the first semiconductor body (500) and including:
an upper first solar subcell (A2) composed of a semiconductor material having a first band gap, and including a top contact (727) on the top surface thereof;
a second solar subcell (B2) adjacent to said first solar subcell (A2) and composed of a semiconductor material having a second band gap smaller than the first band gap and being lattice matched with the upper first solar subcell (A2);
a third solar subcell (C2) adjacent to said second solar subcell (B2) and composed of a semiconductor material having a third band gap smaller than the second band gap and being lattice matched with the second solar subcell (B2) and having a bottom contact (702e);
an interlayer adjacent to said third solar subcell (C2), said interlayer having a fourth band gap greater than said third band gap; and
a fourth solar subcell (D2) adjacent to said interlayer and composed of a semiconductor material having a fifth band gap smaller than the fourth band gap and being lattice mismatched with the third solar subcell (C2), and including a first contact (702f) on the top surface thereof, and a second contact (750) on the bottom surface thereof connected to the terminal of a second polarity (808);
(c) wherein the top contact (625) of the first semiconductor body (500) is electrically coupled with the top contact (725) of the second semiconductor body (700) and to a terminal of first polarity (807);
wherein the first contact (602f) on the top surface of the fourth solar subcell (D1) of the first semiconductor body (500) is electrically coupled with the bottom contact (702e) of the third solar subcell (C2) of the second semiconductor body (700);
the second contact (650) on the bottom surface of the fourth solar subcell (D1) of the first semiconductor body (500) is electrically coupled with the first contact (702f) on the top surface of the fourth solar subcell (D2) of the second semiconductor body (700) thereof so as to form a five junction solar cell;
the short circuit current density of each fourth subcell (D1, D2) being at least twice that of the solar subcells in each semiconductor body (500, 700) which are connected in a series with the fourth subcell (D1, D2);
and wherein the interlayer in each of the first and second semiconductor bodies (500, 700) is compositionally graded to substantially lattice match the third solar subcell (C1, C2) on one side and the fourth solar subcell (D1, D2) on the other side, and is composed of (Al)InₓGa₁₋ₓAs or InₓGa₁₋ₓP with 0 < x < 1, and (A1) designates that aluminum is an optional constituent, subject to the constraints of having the in-plane lattice parameter less than or equal to that of the third solar subcell (C1, C2) and greater than or equal to that of the lower fourth solar subcell (D1, D2);
wherein the fourth subcell (Dl, D2) has a band gap of approximately 0.67 eV, the third subcell (C1, C2) has a band gap in the range of approximately 1.41 eV to 1.31 eV, the second subcell (B1, B2) has a band gap in the range of approximately 1.65 to 1.8 eV and the upper first subcell (A1, A2) has a band gap in the range of 2.0 to 2.20 eV; and wherein:
the upper first subcell (A1, A2) is composed of indium gallium aluminum phosphide;
the second solar subcell (Bl, B2) includes an emitter layer composed of indium gallium phosphide or aluminum gallium arsenide or indium aluminum gallium arsenide, and a base layer composed of aluminum gallium arsenide, indium gallium arsenide phosphide or indium aluminum gallium arsenide;
the third solar subcell (C1, C2) is composed of indium gallium arsenide;
the fourth subcell (Dl, D2) is composed of germanium;
wherein the first (500) and second (700) semiconductor bodies further comprise a first highly doped lateral conduction layer (602b) disposed adjacent to and above the fourth solar subcell (D1) and a blocking p-n diode or insulating layer (602c) disposed adjacent to and above the first highly doped lateral conduction layer (602b), and a second highly doped lateral conduction layer disposed (602d) adjacent to and above the blocking p-n diode or insulating layer (602c).

2. A multijunction solar cell assembly as defined in claim 1, the third subcell (C1, C2) has a band gap of approximately 1.37 eV, the second subcell (Bl, B2) has a band gap of approximately 1.73 eV and the upper first subcell (A1, A2) has a band gap of approximately 2.10 eV.

3. A multijunction solar cell assembly as defined in claim 1, wherein the band gap of the interlayer is in the range of 1.41 eV to 1.6 eV throughout its thickness.

4. A multijunction solar cell assembly as defined in claim 1, further comprising:
a distributed Bragg reflector layer (608) adjacent to and between the third (C1, C2) and the fourth (Dl, D2) solar subcells and arranged so that light can enter and pass through the third solar subcell (C1, C2) and at least a portion of which can be reflected back into the third solar subcell (C1, C2) by the distributed Bragg reflector layer (608), and the distributed Bragg reflector layer (608) is composed of a plurality of alternating layers of lattice matched materials with discontinuities in their respective indices of refraction and the difference in refractive indices between alternating layers is maximized in order to minimize the number of periods required to achieve a given reflectivity, and the thickness and refractive index of each period determines the stop band and its limiting wavelength, and wherein the distributed Bragg reflector layer (608) includes a first distributed Bragg reflector layer (608) composed of a plurality of p type AlₓGa₁₋ₓ(In)As layers, and a second distributed Bragg reflector layer (608) disposed over the first distributed Bragg reflector layer (608) and composed of a plurality of n type or p type Al_{y}Ga_{1-y}(In)As layers, where 0 < x < 1, 0 < y < 1, and y is greater than x, and (In) designates that indium is an optional constituent.

5. A multijunction solar cell assembly as defined in claim 1, wherein the short circuit current density (J_{sc}) of the first (A1, A2), second (B1, B2) and third (C1, C2) subcells are approximately 11 mA/cm², and the short circuit current density (J_{sc}) of the fourth subcell (D1, D2) is approximately 34 mA/cm².

6. A multijunction solar cell assembly as defined in claim 1, wherein at least the base of at least one of the first (A1, A2), second (B1, B2) or third (C1, C2) solar subcells has a graded doping.

7. A multijunction solar cell assembly as defined in claim 1 comprising:
a first opening in the first semiconductor body (500) extending from a top surface of the semiconductor body (500) to the first lateral conduction layer (602b);
a second opening in the first semiconductor body (500) extending from the top surface of the semiconductor body (500) to the second lateral conduction layer (602d); and
a third opening in the first semiconductor body (500) extending from a surface of the first semiconductor body (500) to the p-type semiconductor material of the fourth subcell (D1), a first metallic contact pad (602f, 702f) disposed on the first lateral conduction layer (602b) of each of the first (500) and second (700) semiconductor bodies;
a second metallic contact pad (602e) disposed on the second lateral conduction layer (602d) of the first semiconductor body (500); and
an electrical interconnect connecting the first and second contact pads, a third metallic contact pad (702e) disposed on the second lateral conduction layer (702d) of the second semiconductor body (700);
a fourth metallic contact pad (651) disposed on the p-type semiconductor material of the fourth subcell (D1) of the first semiconductor body (500); and
an electrical interconnect (804) connecting the third and fourth (651) contact pads.

## Patentansprüche

1. Mehrfach-Solarzellen-Baugruppe mit einem Anschluss einer ersten Polarität (807) und einem Anschluss einer zweiten Polarität (808), enthaltend:
(a) einen ersten Halbleiterkörper (500), einschließend:
eine obere erste Solarunterzelle (A1), die zusammengesetzt ist aus einem Halbleitermaterial, das eine erste Bandlücke aufweist, und die einen oberen Kontakt (627) auf der oberen Oberfläche davon einschließt;
eine zweite Solarunterzelle (B1) angrenzend zu besagter ersten Solarunterzelle (A1) und zusammengesetzt aus einem Halbleitermaterial, das eine zweite Bandlücke aufweist, die kleiner ist als die erste Bandlücke, und die an die obere erste Solarunterzelle (A1) gitterangepasst ist;
eine dritte Solarunterzelle (C1) angrenzend zu besagter zweiten Solarunterzelle (B1) und zusammengesetzt aus einem Halbleitermaterial, das eine dritte Bandlücke aufweist, die kleiner ist als die zweite Bandlücke, und die an die zweite Solarunterzelle (B1) gitterangepasst;
eine Zwischenschicht angrenzend zu besagter dritten Solarunterzelle (C1), wobei besagte Zwischenschicht eine vierte Bandlücke aufweist, die größer ist als besagte dritte Bandlücke; und
eine vierte Solarunterzelle (D1) angrenzend zu besagter Zwischenschicht und zusammengesetzt aus einem Halbleitermaterial, das eine fünfte Bandlücke aufweist, die kleiner als die vierte Bandlücke ist, und die an die dritte Solarunterzelle (C1) gitterfehlangepasst ist und die einen ersten Kontakt (602f) an der oberen Oberfläche davon und einen zweiten Kontakt (650) an der unteren Oberfläche davon einschließt;
(b) einen zweiten Halbleiterkörper (700), der angrenzend zu dem ersten Halbleiterkörper (500) angeordnet ist und der einschließt:
eine obere erste Solarunterzelle (A2), die aus einem Halbleitermaterial zusammengesetzt ist, das eine erste Bandlücke aufweist, und die einen oberen Kontakt (727) auf der oberen Oberfläche davon einschließt;
eine zweite Solarunterzelle (B2) angrenzend zu besagter ersten Solarunterzelle (A2) und zusammengesetzt aus einem Halbleitermaterial, das eine zweite Bandlücke aufweist, die kleiner als ist die erste Bandlücke, und die an die obere erste Solarunterzelle (A2) gitterangepasst ist;
eine dritte Solarunterzelle (C2) angrenzend zu besagter zweiten Solarunterzelle (B2) und zusammengesetzt aus einem Halbleitermaterial, das eine dritte Bandlücke aufweist, die kleiner ist als die zweite Bandlücke, und die an die zweite Solarunterzelle (B2) gitterangepasst ist und einen unteren Kontakt (702e) aufweist;
eine Zwischenschicht angrenzend zu besagter dritten Solarunterzelle (C2), wobei besagte Zwischenschicht eine vierte Bandlücke aufweist, die größer ist als besagte dritte Bandlücke; und
eine vierte Solarunterzelle (D2) angrenzend zu besagter Zwischenschicht und zusammengesetzt aus einem Halbleitermaterial, das eine fünfte Bandlücke aufweist, die kleiner als die vierte Bandlücke ist, und die an die dritte Solarunterzelle (C2) gitterfehlangepasst ist und die einen ersten Kontakt (702f) an der oberen Oberfläche davon und einen zweiten Kontakt (750) an der unteren Oberfläche davon aufweist, der mit dem Anschluss einer zweiten Polarität (808) verbunden ist;
(c) wobei der obere Kontakt (625) des ersten Halbleiterkörpers (500) mit dem oberen Kontakt (725) des zweiten Halbleiterkörpers (700) und einem Anschluss einer ersten Polarität (807) elektrisch gekoppelt ist;
wobei der erste Kontakt (602f) an der oberen Oberfläche der vierten Solarunterzelle (D1) des ersten Halbleiterkörpers (500) mit dem unteren Kontakt (702e) der dritten Solarunterzelle (C2) des zweiten Halbleiterkörpers (700) elektrisch gekoppelt ist;
der zweite Kontakt (650) an der unteren Oberfläche der vierten Solarunterzelle (D1) des ersten Halbleiterkörpers (500) mit dem ersten Kontakt (702f) auf der oberen Oberfläche der vierten Solarunterzelle (D2) des zweiten Halbleiterkörpers (700) elektrisch gekoppelt ist, um eine Fünffach-Solarzelle zu bilden;
die Kurzschlussstromdichte jeder vierten Unterzelle (D1, D2) mindestens doppelt so groß ist wie die der Solarunterzellen in jedem Halbleiterkörper (500, 700), die in einer Reihe mit der vierten Unterzelle (D1, D2) verbunden sind;
und wobei die Zwischenschicht in jedem der ersten und zweiten Halbleiterkörper (500, 700) kompositorisch abgestuft ist, um im Wesentlichen an die dritte Solarunterzelle (C1, C2) auf der einen Seite und die vierte Solarunterzelle (D1, D2) auf der anderen Seite gitterangepasst zu sein, und zusammengesetzt ist aus (Al)InₓGa₁₋ₓ As oder InₓGa₁₋ₓP, wobei 0<x0<1 und (Al) bezeichnet, dass Aluminium ein optionaler Bestandteil ist, mit der Maßgabe, dass der Gitterparameter in der Ebene kleiner oder gleich dem der dritten Solarunterzelle (C1, C2) ist und größer oder gleich dem der unteren vierten Solarunterzelle (D1, D2) ist;
wobei die vierte Unterzelle (D1, D2) eine Bandlücke von etwa 0,67 eV aufweist, die dritte Unterzelle (C1, C2) eine Bandlücke in dem Bereich von etwa 1,41 eV bis 1,31 eV, die zweite Unterzelle (B1, B2) eine Bandlücke im Bereich von etwa 1,65 bis 1,8 eV aufweist und die obere erste Unterzelle (A1, A2) eine Bandlücke im Bereich von 2,0 bis 2,20 eV aufweist; und wobei:
die obere erste Unterzelle (A1, A2) aus Indium-Gallium-Aluminiumphosphid zusammengesetzt ist;
die zweite Solarunterzelle (B1, B2) eine Emitterschicht, die aus Indium-Galliumphosphid oder Aluminium-Galliumarsenid oder Indium-Aluminum Galliumarsenid zusammengesetzt ist, und eine Basisschicht einschließt, die aus Aluminium-Galliumarsenid, Indium-Galliumarsenidphosphid oder Indiumaluminium-Galliumarsenid zusammengesetzt ist;
die dritte Solarunterzelle (C1, C2) aus Indium-Galliumarsenid zusammengesetzt ist;
die vierte Unterzelle (D1, D2) aus Germanium zusammengesetzt ist;
wobei der erste (500) und der zweite (700) Halbleiterkörper ferner eine erste hochdotierte laterale Leitschicht (602b), die angrenzend zu und auf der vierten Solarunterzelle (D1) angeordnet ist, und eine p-n-Sperrdiode oder Isolierschicht (602c), die angrenzend zu und auf der ersten hochdotierten lateralen Leitschicht (602b) angeordnet ist, und eine zweite hochdotierte laterale Leitschicht (602d) enthalten, die angrenzend zu und auf der p-n-Sperrdiode oder Isolierschicht (602c) angeordnet ist.

2. Mehrfach-Solarzellen-Baugruppe gemäß Anspruch 1, wobei die dritte Unterzelle (C1, C2) eine Bandlücke von etwa 1,37 eV aufweist, die zweite Unterzelle (B1, B2) eine Bandlücke von etwa 1,73 eV aufweist und die obere erste Unterzelle (A1, A2) eine Bandlücke von etwa 2,10 eV aufweist.

3. Mehrfach-Solarzellen-Baugruppe gemäß Anspruch 1, wobei die Bandlücke der Zwischenschicht in dem Bereich von 1,41 eV bis 1,6 eV über ihre gesamte Dicke liegt.

4. Mehrfach-Solarzellen-Baugruppe gemäß Anspruch 1, die ferner enthält:
eine verteilte Bragg-Reflektor- bzw. Distributed Bragg Reflector-Schicht (608) angrenzend zu und zwischen der dritten (C1, C2) und der vierten (D1, D2) SolarUnterzellen und so angeordnet, dass Licht in die dritte Solarunterzelle (C1, C2) eintreten und durchgehen kann und zumindest ein Teil davon durch die verteilte Bragg-Reflektor-Schicht (608) in die dritte Solarunterzelle (C1, C2) zurückreflektiert werden kann, und wobei die verteilte Bragg-Reflektor-Schicht (608) zusammengesetzt ist aus einer Vielzahl von abwechselnden Schichten von gitterangepassten Materialien mit Diskontinuitäten in ihren jeweiligen Brechungsindizes und die Differenz der Brechungsindizes zwischen den abwechselnden Schichten maximiert ist, um die Anzahl der Perioden zu minimieren, die erforderlich sind, um eine bestimmte Reflektivität zu erreichen, und die Dicke und der Brechungsindex jeder Periode die Sperrbande und ihre begrenzende Wellenlänge bestimmen, und wobei die verteilte Bragg-Reflektor-Schicht (608) eine erste verteilte Bragg-Reflektor-Schicht (608), die aus einer Vielzahl von p-Typ AlₓGa₁₋ₓ(In)Al-Schichten zusammengesetzt ist, und eine zweite verteilte Bragg-Reflektor-Schicht (608) einschließt, die auf der ersten verteilten Bragg-Reflektor-Schicht (608) angeordnet ist und aus einer Vielzahl von n-Typs oder p Typ Al_{y}Ga_{1-y}(In)Al-Schichten zusammengesetzt ist, wobei 0 < x < 1, 0 < y < 1 und y größer als x ist und (In) bezeichnet, dass Indium ein optionaler Bestandteil ist.

5. Mehrfach-Solarzellen-Baugruppe gemäß Anspruch 1, wobei die Kurzschlussstromdichte (J_{sc}) der ersten (A1, A2), zweiten (B1, B2) und dritten (C1, C2) Unterzellen etwa 11 mA/cm² beträgt und die Kurzschlussstromdichte (J_{sc}) der vierten Unterzelle (D1, D2) etwa 34 mA/cm² beträgt.

6. Mehrfach-Solarzellen-Baugruppe gemäß Anspruch 1, wobei mindestens die Basis von mindestens einer der ersten (A1, A2),zweiten (B1, B2) oder dritten (C1, C2) Solarunterzellen eine abgestufte Dotierung aufweist.

7. Mehrfach-Solarzellen-Baugruppe gemäß Anspruch 1, die enthält:
eine erste Öffnung in dem ersten Halbleiterkörper (500), die sich von einer oberen Oberfläche des Halbleiterkörpers (500) zu der ersten lateralen Leitschicht (602b) erstreckt;
eine zweite Öffnung in dem ersten Halbleiterkörper (500), die sich von der oberen Oberfläche des Halbleiterkörpers (500) zu der zweiten lateralen Leitschicht (602d) erstreckt; und
eine dritte Öffnung in dem ersten Halbleiterkörper (500), die sich von einer Oberfläche des ersten Halbleiterkörpers (500) zu dem p-Typ-Halbleitermaterial der vierten Unterzelle (D1) erstreckt, ein erstes metallisches Kontaktpad (602f, 702f), das auf der ersten lateralen Leitschicht (602b) jedes der ersten (500) und zweiten (700) Halbleiterkörper angeordnet ist;
ein zweites metallisches Kontaktpad (602e), das auf der zweiten lateralen Leitschicht (602d) des ersten Halbleiterkörpers (500) angeordnet ist; und
eine elektrische Verbindung, die die ersten und zweiten Kontaktpads verbindet, ein drittes metallisches Kontaktpad (702e), das auf der zweiten lateralen Leitschicht (702d) des zweiten Halbleiterkörpers (700) angeordnet ist;
ein viertes metallisches Kontaktpad (651), das auf dem p-Typ Halbleitermaterial der vierten Unterzelle (D1) des ersten Halbleiterkörpers (500) angeordnet ist; und
eine elektrische Verbindung (804), die das dritte und vierte (651) Kontaktpad verbindet.

## Revendications

1. Un assemblage de cellules solaires multijonctions ayant un terminal d'une première polarité (807) et un terminal d'une deuxième polarité (808) comprenant :
(a) un premier corps semi-conducteur (500), incluant :
une première sous-cellule solaire supérieure (A1) composée d'un matériau semi-conducteur ayant une première bande interdite, et incluant un contact supérieur (627) sur la surface supérieure de celle-ci;
une deuxième sous-cellule solaire (B1) adjacente à ladite première sous-cellule solaire (A1) et composée d'un matériau semi-conducteur ayant une deuxième bande interdite inférieure à la première bande interdite et étant adaptée en réseau à la première sous-cellule solaire supérieure (A1);
une troisième sous-cellule solaire (C1) adjacente à ladite deuxième sous-cellule solaire (B1) et composée d'un matériau semi-conducteur ayant une troisième bande interdite inférieure à la deuxième bande interdite et étant adaptée en réseau à la deuxième sous-cellule solaire (B1);
une couche intermédiaire adjacente à ladite troisième sous-cellule solaire (C1), dans lequel la couche intermédiaire a une quatrième bande interdite supérieure à ladite troisième bande interdite; et
une quatrième sous-cellule solaire (D1) adjacente à ladite couche intermédiaire et composée d'un matériau semi-conducteur ayant une cinquième bande interdite inférieure à la quatrième bande interdite et étant non-adaptée en réseau à la troisième sous-cellule solaire (C1), et incluant un premier contact (602f) sur la surface supérieure de celle-ci et un deuxième contact (650) sur la surface inférieure de celle-ci;
(b) un deuxième corps semi-conducteur (700) disposé adjacent et parallèle au premier corps semi-conducteur (500) et incluant :
une première sous-cellule solaire supérieure (A2) composée d'un matériau semi-conducteur ayant une première bande interdite, et incluant un contact supérieur (727) sur la surface supérieure de celle-ci;
une deuxième sous-cellule solaire (B2) adjacente à ladite première sous-cellule solaire (A2) et composée d'un matériau semi-conducteur ayant une deuxième bande interdite inférieure à la première bande interdite et étant adaptée en réseau à la première sous-cellule solaire supérieure (A2);
une troisième sous-cellule solaire (C2) adjacente à la dite deuxième sous-cellule solaire (B2) et composée d'un matériau semi-conducteur ayant une troisième bande interdite inférieure à la deuxième bande interdite et étant adaptée en réseau à la deuxième sous-cellule solaire (B2) et ayant un contact inférieur (702e);
une couche intermédiaire adjacente à ladite troisième sous-cellule solaire (C2), dans lequel la couche intermédiaire a une quatrième bande interdite supérieure à ladite troisième bande interdite; et
une quatrième sous-cellule solaire (D2) adjacente à ladite couche intermédiaire et composée d'un matériau semi-conducteur ayant une cinquième bande interdite inférieure à la quatrième bande interdite et étant non-adapté en réseau à la troisième sous-cellule solaire (C2) et incluant un premier contact (702f) sur la surface supérieure de celle-ci et un deuxième contact (750) sur la surface inférieure de celle-ci relié au terminal d'une deuxième polarité (808);
(c) dans lequel le contact supérieur (625) du premier corps semi-conducteur (500) est couplé électriquement avec le contact supérieur (725) du deuxième corps semi-conducteur (700) et à un terminal de première polarité (807);
dans lequel le premier contact (602f) sur la surface supérieure de la quatrième sous-cellule solaire (D1) du premier corps semi-conducteur (500) est électriquement couplé avec le contact inférieur (702e) de la troisième sous-cellule solaire (C2) du deuxième corps semi-conducteur (700);
le deuxième contact (650) à la surface inférieure de la quatrième sous-cellule solaire (D1) du premier corps semi-conducteur (500) est couplé électriquement avec le premier contact (702f) sur la surface supérieure de la quatrième sous-cellule solaire (D2) du deuxième corps semi-conducteur (700) de celui-ci afin de former une cellule solaire à cinq jonctions;
la densité de courant de court-circuit de chaque quatrième sous-cellule (D1, D2) étant au moins deux fois celle des sous-cellules solaires de chaque corps semi-conducteur (500 700) qui sont reliées en série à la quatrième sous-cellule (D1, D2);
et dans lequel la couche intermédiaire dans chacun des premier et deuxième corps semi-conducteurs (500 700) est graduée en composition pour être substantiellement adaptée en réseau à la troisième sous-cellule solaire (C1, C2) d'un côté et à la quatrième sous-cellule solaire (D1, D2) de l'autre côté, et est composée d'(Al)InₓGa₁₋ₓAs ou InₓGa₁₋ₓP avec 0 < x < 1, et (Al) désigne qu'Al est un constituant facultatif, soumis aux contraintes que le paramètre de réseau en plan soit inférieur ou égal à celui de la troisième sous-cellule solaire (C1, C2) et supérieur ou égal à celui de la quatrième sous-cellule solaire inférieure (D1, D2);
dans lequel la quatrième sous-cellule (D1, D2) a une bande interdite d'environ 0,67 eV, la troisième sous-cellule (C1, C2) a une bande interdite de l'ordre d'environ 1,41 eV à 1,31 eV, la deuxième sous-cellule (B1, B2) a une bande interdite de l'ordre d'environ 1,65 à 1,8 eV et la première sous-cellule supérieure (A1, A2) a une bande interdite de l'ordre de 2,0 à 2,20 eV; et dans lequel:
la première sous-cellule supérieure (A1, A2) est composée de phosphide d'aluminium gallium indium;
la deuxième sous-cellule solaire (B1, B2) comprend une couche d'émetteur composée de phosphide d'indium gallium ou d'arséniure d'aluminium gallium ou d'arséniure d'indium aluminium gallium et d'une couche de base composée d'arséniure d'aluminium gallium, d'arséniure de phosphide d'indium gallium ou de d'arséniure d'indium aluminium gallium;
la troisième sous-cellule solaire (C1, C2) est composée d'arséniure d'indium gallium;
la quatrième sous-cellule (D1, D2) est composée de germanium;
dans lequel le premier (500) et le deuxième (700) corps semi-conducteurs comprennent en outre une première couche de conduction latérale fortement dopée (602b) disposée adjacente et au-dessus de la quatrième sous-cellule solaire (D1) et une p-n diode de blocage ou une couche isolante (602c) disposée adjacente et au-dessus de la première couche de conduction latérale fortement dopée (602b) et une deuxième couche de conduction latérale fortement dopée (602d) adjacente et au-dessus de la p-n diode de blocage ou de la couche isolante (602c).

2. Un assemblage de cellules solaires multijonctions selon la revendication 1, dans lequel la troisième sous-cellule (C1, C2) a une bande interdite d'environ 1,37 eV, la deuxième sous-cellule (B1, B2) a une bande interdite d'environ 1,73 eV et la première sous-cellule supérieure (A1, A2) a une bande interdite d'environ 2,10 eV.

3. Un assemblage de cellules solaires multijonctions selon la revendication 1, dans lequel la bande interdite de la couche intermédiaire est de l'ordre de 1,41 eV à 1,6 eV tout au long de son épaisseur.

4. Un assemblage de cellules solaires multijonctions selon la revendication 1, comprenant en outre :
une couche de réflecteur Bragg distribué (608) adjacente et comprise entre la troisième (C1, C2) et la quatrième (D1, D2) sous-cellules solaires et disposée de sorte que la lumière puisse entrer et passer à travers la troisième sous-cellule solaire (C1, C2) et au moins une partie de celle-ci peut être réfléchie vers l'intérieur de la troisième sous-cellule solaire (C1, C2) par la couche de réflecteur Bragg distribué (608), et la couche de réflecteur Bragg distribué (608) est composée d'une pluralité de couches alternées de matériaux adaptés en réseau avec des discontinuités dans leurs indices respectives de réfraction et la différence d'indices de réfraction entre les couches alternées est maximisée afin de minimiser le nombre de périodes nécessaires pour atteindre une réflectivité donnée, et l'épaisseur et l'indice de réfraction de chaque période détermine la bande de fin et sa longueur d'onde limitative, et dans lequel la couche de réflecteur Bragg distribué (608) inclut une première couche de réflecteur Bragg distribué (608) composée d'une pluralité couches de p type d'AlₓGa₁₋ₓ(In)As et une deuxième couche de réflecteur Bragg distribué (608) disposée sur la première couche de réflecteur Bragg distribué (608) et composée d'une pluralité de couches de n type ou de type p d'Al_{y}Ga_{1-y}(In) As, dans lequel 0 < x < 1, 0 < y < 1, et y est supérieur à x, et (In) désigne que l'indium est un constituant facultatif.

5. Un assemblage de cellules solaires multijonctions selon la revendication 1, dans lequel la densité de courant de court-circuit (J_{sc}) de la première (A1, A2), la deuxième (B1, B2) et la troisième sous-cellule (C1, C2) sont d'environ 11 mA/cm², et la densité de courant de court-circuit (J_{sc}) de la quatrième sous-cellule inférieure (D1, D2) est d'environ 34 mA/cm².

6. Un assemblage de cellules solaires multijonctions selon la revendication 1, dans lequel au moins la base d'au moins une des premières (A1, A2), deuxième (B1, B2) ou troisième (C1, C2) sous-cellules solaires a un dopage gradué.

7. Un assemblage de cellules solaires multijonctions selon la revendication 1, comprenant :
une première ouverture dans le premier corps semi-conducteur (500) s'étendant d'une surface supérieure du corps semi-conducteur (500) à la première couche latérale de conduction (602b);
une deuxième ouverture dans le premier corps semi-conducteur (500) s'étendant de la surface supérieure du corps semi-conducteur (500) à la deuxième couche latérale de conduction (602d); et
une troisième ouverture dans le premier corps semi-conducteur (500) s'étendant d'une surface du premier corps semi-conducteur (500) au matériau semi-conducteur de type p de la quatrième sous-cellule (D1),
un premier plot de contact métallique (602f, 702f) disposé sur la première couche latérale de conduction (602b) de chacun des premiers (500) et deuxième (700) corps semi-conducteurs;
un deuxième plot de contact métallique (602e) disposé sur la deuxième couche latérale de conduction (602d) du premier corps semi-conducteur (500);et
une interconnexion électrique reliant les premier et deuxième plots de contact, un troisième plot de contact métallique (702e) disposé sur la deuxième couche latérale de conduction (702d) du deuxième corps semi-conducteur (700);
un quatrième plot de contact métallique (651) disposé sur le matériau semi-conducteur de type p de la quatrième sous-cellule (D1) du premier corps semi-conducteur (500); et
une interconnexion électrique (804) reliant les troisième et quatrième (651) plots de contact.
